(19) Europäisches Patentamt
European Patent Office
Office européen des brevets

(11) Veröffentlichungsnummer: **0 196 999 B1**

# (12) EUROPÄISCHE PATENTSCHRIFT

(45) Veröffentlichungstag der Patentschrift: **08.01.92 Patentblatt 92/02**

(51) Int. Cl.$^5$: **C08G 8/28,** C09D 5/44, G03F 7/00

(21) Anmeldenummer: **86810094.2**

(22) Anmeldetag: **24.02.86**

## (54) Modifizierte Phenolharze.

Die Akte enthält technische Angaben, die nach dem Eingang der Anmeldung eingereicht wurden und die nicht in dieser Patentschrift enthalten sind.

(30) Priorität: **02.03.85 GB 8505402**

(43) Veröffentlichungstag der Anmeldung: **08.10.86 Patentblatt 86/41**

(45) Bekanntmachung des Hinweises auf die Patenterteilung: **08.01.92 Patentblatt 92/02**

(84) Benannte Vertragsstaaten: **BE CH DE FR GB IT LI NL SE**

(56) Entgegenhaltungen:
**EP-A- 0 070 201**
**EP-A- 0 109 062**
**EP-A- 0 150 315**
**EP-A- 0 184 553**
**US-A- 4 115 128**

(73) Patentinhaber: **CIBA-GEIGY AG**
**Klybeckstrasse 141**
**CH-4002 Basel (CH)**

(72) Erfinder: **Demmer, Christopher George, Dr.**
**20 Wolsey Way**
**Cambridge CB1 3JG (GB)**
Erfinder: **Irving, Edward, Dr.**
**41, Swaffham Road**
**Burwell Cambridge CB5 0AN (GB)**

**EP 0 196 999 B1**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist (Art. 99(1) Europäisches Patentübereinkommen).

Jouve, 18, rue Saint-Denis, 75001 PARIS

**Beschreibung**

Vorliegende Erfindung betrifft neue modifizierte Phenolharzprodukte sowie Verfahren zu deren Herstellung; diese neuen Produkte sind sowohl lichtempfindlich als auch galvanisch abscheidbar.

Lichtempfindliche Phenolnovolakharze sind wohlbekannt und werden hauptsächlich zur Herstellung präsensibilisierter lithographischer Platten verwendet. Sie werden üblicherweise durch Kondensation eines Phenolharzes mit einem Chinondiazidsulfonylchlorid hergestellt, was dank der Gegenwart der Chinondiazidgruppen ein Produkt mit Lichtempfindlichkeit sowie wegen der Gegenwart des Novolakharz"Rückgrats" gute Haftung und Zähigkeit ergibt. Mit diesen Materialien beschichtete Platten widerstehen dem mechanischen Abrieb im lithographischen Druckverfahren.

In der britischen Patentschrift Nr. 1 227 602 wird beispielsweise eine präsensibilisierte lithographische Platte mit einer Schicht eines wasserunlöslichen Kondensationsprodukts beschrieben, das einen Ester einer Benzooder Naphthochinondiazidsulfonsäure mit einem phenolische Hydroxylgruppen enthaltenden Harz darstellt, wobei ein Kresol/Formaldehydharz als Beispiel angegeben ist. Aus der britischen Patentschrift Nr. 1 329 888 ist ein Kondensationsprodukt eines para-substituierten Phenolharzes mit einer Alkyl-, Aryl-, Alkoxy-, Sulfoalkyl-, Aryloxy-, Aralkyl-oxy-, Carbalkoxy-, Aralkyl- oder Acetylgruppe in der para-Stellung zur phenolischen Hydroxylgruppe mit einem Sulfonylchlorid des o-Benzochinondiazids oder o-Naphthochinondiazids bekannt. Diese Kondensationsprodukte sollen bei der Herstellung präsensibilisierter Platten für photomechanische Verfahren besonders nützlich sein.

Die britische Patentschrift Nr. 1 330 932 beschreibt Kondensationsprodukte von Benzo- oder Naphthochinondiazidsulfonylchloriden mit aus einem Bisphenol und Formaldehyd hergestellten Novolaken. Diese Produkte sollen bei der Herstellung präsensibilisierter Platten für lithographische Verfahren nützlich sein. Schliesslich offenbart U.S. Patent Nr. 4 306 010 Kondensationsprodukte aus o-Benzo- oder o-Naphthochinondiazidsulfonylchloriden mit einem aus einem mehrwertigen Phenol hergestellten Harz, wie Resorcin/Benzaldehydharz oder Resorcin/4-Methylbenzaldehydharz. Diese Produkte sollen sich zur Herstellung lichtempfindlicher Platten zur Verwendung bei der Lithographie eignen. Positive Photoresists auf Grundlage von Gemischen herkömmlicher, mit Chinondiaziden modifizierter Phenolharze und Säureanhydride sind beschrieben worden, doch geben solche Gemische bei der galvanischen Abscheidung keine zufriedenstellenden Filme.

Ausserdem beschreiben die US-Patentschrift Nr. 4115128 und die europäische Patentanmeldung Nr. 70201 photoempfindliche Gemische die ein phenolisches Harz, ein Chinondiazidsulfonsäurederivat und ein Polycarbonsäureanhydrid enthalten Dabei wird das Polycarbonsaürean hydrid dem Gemisch insbesondere zur Verbesserung der photographischen Geschwindig heit der damit hergestellten Erzeugnisse, z.B. lithographischen Druckplatte zugesetzt.

Die galvanische Abscheidung positiv arbeitender Photoresists besitzt den Vorteil, dass sehr gleichförmige Bedeckung erhältlich ist, was besonders an Kanten und durchplattierten Löchern wichtig ist, wenn verhältnismässig dünne Photoresistfilme verwendet werden. Die Verwendung dünner, gleichförmiger Filme ermöglicht verbesserte Auflösung gegenüber herkömmlichen Film- und flüssigen Photoresists. Ein weiterer Vorteil besteht darin, dass die Notwendigkeit für grosse "Stützringe" oder "Inseln" zum Abstützen von Photopolymerfilmen über durchplattierten Löchern verringert ist und somit eine grössere Fläche der Leiterplatte für Leiterbahnen verfügbar ist. Ferner lassen sich galvanisch abscheidbare Photoresists mit einem Mindestgehalt an organischem Lösungsmittel formulieren, und sie können mit sehr hohem Feststoffgehalt abgeschieden werden, was zu wichtigen Sicherheits- und Umweltvorteilen führt. Schliesslich ist die Resistausnutzung sehr hoch, und völlige Automatisierung des Beschichtungsverfahrens ist möglich.

Es wurde nun gefunden, dass gewisse, Chinondiazidgruppen enthaltende Novolakharze galvanisch abscheidbar sind und dabei Beschichtungen ergeben, die sich zur Verwendung bei der Herstellung gedruckter Schaltungen mit den oben angegebenen Vorteilen eignen. Die Möglichkeit zur galvanischen Abscheidung solcher Harze hängt davon ab, dass sie zumindest teilweise in Form von Salzen vorliegen. Die Herstellung neuer Harze mit einer lichtempfindlichen Chinondiazidgruppe und einer Carboxylgruppe gestattet es, die erforderliche galvanische Abscheidbarkeit ohne Verlust an Lichtempfindlichkeit zu erzielen.

Gegenstand der Erfindung sind dementsprechend zumindest teilweise in Form von Salzen vorliefende galvanisch abscheidbare, lichtempfindliche modifizierte Phenolnovolakharze der allgemeinen Formel

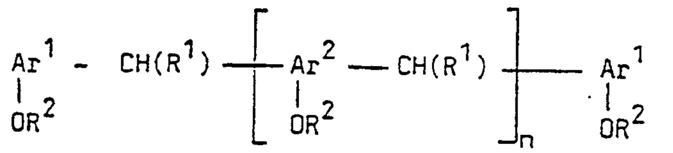

I

worin $Ar^1$ für eine über aromatische Kohlenstoffatome an die angegebenen Gruppen $-OR^2$ und $-CH(R^1)-$ gebundene zweiwertige aromatische Gruppe, $Ar^2$ für eine über aromatische Kohlenstoffatome an die angegebenen Gruppen $-OR^2$ und $-CH(R^1)$gebundene dreiwertige aromatische Gruppe, $R^1$ für ein Wasserstoffatom oder eine Alkyl-, Aryl- oder Carboxylgruppe, $R^2$ für ein Wasserstoffatom, eine gegebenenfalls durch eine Hydroxyl- oder Alkoxygruppe substituierte Alkylgruppe oder eine Gruppe der Formel $-CO-R^3-COOH$, $-SO_2R^4$, $-COR^5$ oder $-SO_2R^5$, wobei mindestens 1% der Gruppen $R^2$ eine Gruppe $-CO-R^3-COOH$ und mindestens 4% der Gruppen $R^2$ eine Gruppe $-SO_2R^4$ bedeuten, wobei $R^3$ eine zweiwertige aliphatische, cycloaliphatische, aromatische oder araliphatische Gruppe, $R^4$ eine 1,2-Benzochinondiazidgruppe bzw. 1,2-Naphthochinondiazidgruppe der Formel

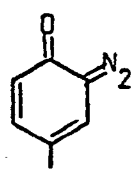

bzw.

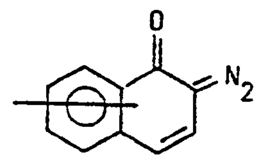

II

III

wobei sich die freie Valenzbindung der Formel III in 4-oder 5-Stellung befindet, $R^5$ eine carboxylfreie, einwertige aliphatische, cycloaliphatische, aromatische oder araliphatische Gruppe bedeutet und n für null oder eine ganze Zahl von 1 bis 20, vorzugsweise 1 bis 10, stehen.

Die aromatischen Gruppen $Ar^1$ und $Ar^2$ besitzen zweckmässig 6 bis 25, vorzugsweise 6 bis 15, Kohlenstoffatome und können an einem aromatischen Kohlenstoffatom einen Substituenten $R^6$ tragen, wobei $R^6$ für ein Halogenatom, eine Gruppe der Formel $-OR^2$, eine gegebenenfalls veresterte Carboxyl- oder Sulfonsäuregruppe, eine gegebenenfalls durch eine Hydroxyl- oder Carboxylgruppe substituierte Alkyl-, Alkenyl- oder Arylgruppe oder eine Gruppe der Formel $-COR^7$ steht, worin $R^7$ eine Alkyl-, Cycloalkyl- oder Arylgruppe bedeutet, oder je eine Gruppe an jedem aromatischen Ring eine Gruppe der Formel

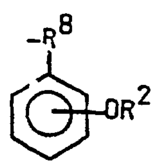

IV

darstellen kann, die gegebenenfalls mit benachbarten aromatischen Ringen über Gruppen $-CH(R^1)-$ verknüpft ist, wobei $R^8$ für ein Sauerstoff- oder Schwefelatom, eine Carbonyl- oder Sulfonylgruppe oder eine gegebenenfalls durch ein Halogenatom, eine gegebenenfalls verätherte Hydroxylgruppe, eine gegebenenfalls veresterte Carboxylgruppe oder eine gegebenenfalls durch ein Halogenatom oder eine gegebenenfalls verätherte Hydroxylgruppe oder gegebenenfalls veresterte Carboxylgruppe substituierte Arylgruppe mit 6 bis 12 Kohlenstoffatomen substituierte Alkylengruppe mit 1 bis 8 Kohlenstoffatomen steht, oder, falls zwei Substituenten $R^6$ an benachbarten Kohlenstoffatomen vorliegen, die beiden Substituenten $R^6$ zusammen mit den Kohlenstoffatomen, an die sie gebunden sind, eine gegebenenfalls substituierte Benzogruppe darstellen.

Die bevorzugten Harze sind solche der allgemeinen Formel

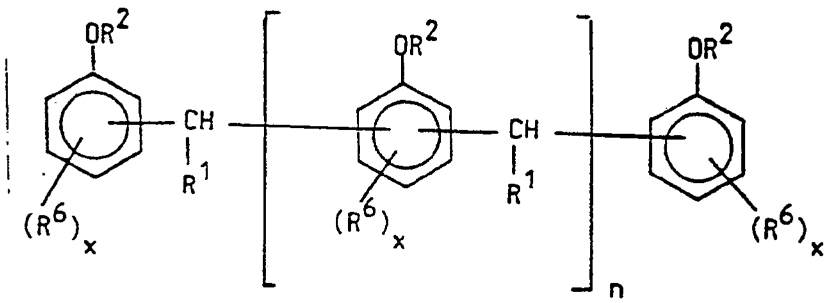

V

worin $R^1$, $R^2$, $R^6$ und n die obigen Bedeutungen haben und x null, 1, 2 oder 3 ist.

Vorzugsweise stellen 8% bis 75%, insbesondere 10% bis 50% und besonders bevorzugt 10 bis 25% der Gruppen $R^2$ eine Chinondiazidsulfonylgruppe der Formel $-SO_2R^4$ dar. Ferner werden vorzugsweise 2% bis 50%, insbesondere 4% bis 30% und besonders bevorzugt 4 bis 20% der Gruppen $R^2$ durch eine Gruppe der Formel $-CO-R^3-COOH$ dargestellt. Alle verbleibenden Gruppen $R^2$ können ein Wasserstoffatom, eine gegebenenfalls durch eine Hydroxyl- or Alkoxygruppe substituierte Alkylgruppe oder eine Gruppe der Formel $-COR^5$ oder $-SO_2R^5$ bedeuten. Es ist vorzuziehen, dass 25% bis 88%, insbesondere 50% bis 85% und besonders bevorzugt 60 bis 85% der Gruppen $R^2$ für ein Wasserstoffatom stehen. In bevorzugten Harzen bedeuten einige der Gruppen $R^2$ $-SO_2R^4$, einige $-CO-R^3-COOH$ und im wesentlichen der ganze Rest Wasserstoff, wobei die obigen bevorzugten und besonders bevorzugten Prozentangaben gelten.

Es ist vorzuziehen, dass Alkyl-, Alkoxy- und Alkenylgruppen unter den Definitionen für $R^1$ $R^2$ $R^6$ und $R^7$ bis zu 20, insbesondere bis zu 10 Kohlenstoffatome, Aryl- und Aralkylgruppen unter den Definitionen für $R^1$, $R^6$ und $R^7$ bis zu 20, insbesondere bis zu 10 Kohlenstoffatome und einwertige Gruppen unter der Definition für $R^5$ sowie zweiwertige Gruppen unter der Definition für $R^3$ bis zu 25, insbesondere bis zu 20, Kohlenstoffatome aufweisen.

$R^1$ steht vorzugsweise für ein Wasserstoffatom, eine Methyl, Aethyl- oder Phenylgruppe oder eine Carboxylgruppe. Harze, in denen $R^1$ für ein Wasserstoffatom oder eine Phenylgruppe steht, werden besonders bevorzugt.

Falls $R^2$ für eine gegebenenfalls substituierte Alkylgruppe steht, enthält ferner die Alkylgruppe vorzugsweise 1 bis 4 Kohlenstoffatome und ist gegebenenfalls durch eine Hydroxylgruppe oder Alkoxygruppe mit 1 bis 4 Kohlenstoffatomen substituiert, wobei Methyl-, Aethyl-, Isopropyl-, n-Butyl-, 2-Hydroxyäthyl-, 2-Hydroxypropyl-, 2-Methoxyäthyl- und 2-Butoxyäthylgruppen besonders bevorzugt sind.

Zu geeigneten zweiwertigen Gruppen $R^3$ zählen aliphatische, cycloaliphatische und aromatische, gegebenenfalls durch ein oder mehrere Halogenatome, Alkoxygruppen mit 1 bis 4 Kohlenstoffatomen oder gegebenenfalls veresterte Carboxylgruppen substituierte Kohlenwasserstoffgruppen. Solche Gruppen $R^3$ sind zweckmässig die Reste aliphatischer, cycloaliphatischer und aromatischer Polycarbonsäuren mit 4 bis 20 Kohlenstoffatomen nach Wegnahme von zwei Carboxylgruppen. Beispiele für geeignete aliphatische Gruppen $R^3$ sind die Reste gesättigter und ungesättigter aliphatischer Dicarbonsäuren mit 4 bis 18 Kohlenstoffatomen, worin die beiden Carboxylgruppen durch eine Kette von 2 bis 3 Kohlenstoffatomen getrennt sind, wie Bernsteinsäure, Glutarsäure, Methylbernsteinsäure, Isooctenylbernsteinsäure (6-Methyl-1-heptenylbernsteinsäure), Nonenylbernsteinsäure, Dodecenylbernsteinsäure, Itaconsäure, Maleinsäure, Dichlormaleinsäure und Citraconsäure.

Geeignete cycloaliphatische Gruppen $R^3$ sind beispielsweise die Reste cycloaliphatischer Dicarbonsäuren mit 5 bis 20, vorzugsweise 5 bis 12 Kohlenstoffatomen, wie Cyclopropan-, Cyclobutan-, Cyclopentan-, Cyclohexan-, Cyclopropen-, Cyclobuten-, Cyclopenten-, Cyclohexen- und Endomethylencyclohexendicarbonsäuren, wobei als solche Säuren Hexahydrophthalsäure, Tetrahydrophthalsäure und Methyltetrahydrophthalsäure sowie Bicyclo[2.2.1]hept-5-en-2,3-dicarbonsäure und deren 1,4,5,6,7,7-Hexachlorderivat bevorzugt werden.

Beispiele für geeignete aromatische Gruppen $R^3$ sind die Reste aromatischer Polycarbonsäuren mit 8 bis 18 Kohlenstoffatomen, wie Phthalsäure, Tetrachlorphthalsäure, Tetrabromphthalsäure und Trimellithsäure.

Besonders bevorzugte Gruppen $R^3$ sind die Reste der Glutarsäure, Isooctenylbernsteinsäure bzw. Phthalsäure nach Wegnahme von zwei Carboxylgruppen, d.h. Trimethylen-, Isooctenyläthylen- bzw. 1,2-Phenylengruppen.

$R^4$ ist vorzugsweise eine 1,2-Naphthochinondiazidgruppe der Formel III.

Zu bevorzugten Gruppen $R^5$ zählen gegebenenfalls halogen- oder hydroxylsubstituierte Alkylgruppen insbesondere mit 1 bis 10 Kohlenstoffatomen sowie gebebenenfalls halogen- oder hydroxylsubstituierte Arylgruppen mit insbesondere 6 bis 10 Kohlenstoffatomen. Methyl, Phenyl und p-Tolyl sind besonders bevorzugte Gruppen $R^5$.

Zu bevorzugten Atomen und Gruppen $R^6$ gehören Chlorund Bromatome, Hydroxylgruppen, Alkoxygruppen mit 1 bis 4 Kohlenstoffatomen, Alkylgruppen mit 1 bis 9 Kohlenstoffatomen, Carboxylgruppen, veresterte Carboxylgruppen mit 2 bis 12 Kohlenstoffatomen, Sulfonsäuregruppen, veresterte Sulfonsäuregruppen mit 1 bis 10 Kohlenstoffatomen, Gruppen der Formel $-OR^2$, Gruppen der Formel $-COR^7$, wobei $R^7$ für eine Alkylgruppe mit 1 bis 4 Kohlenstoffatomen oder eine Arylgruppe mit 6 bis 10 Kohlenstoffatomen steht, Gruppen der Formel IV, worin $R^8$ für eine Methylen- oder Isopropylidengruppe oder eine Gruppe der Formel -CH(COOH)- oder -$C(CH_3)[(CH_2)_2COOH]$- steht, sowie im Fall von zwei Gruppen $R^6$ an benachbarten Kohlenstoffatomen durch die Gruppen $R^6$ und das Kohlenstoffatom, an das sie gebunden sind, gebildete Benzogruppen, wobei diese Kohlenstoffatome sich vorzugsweise in den 2,3-Stellungen zu den angegebenen Gruppen $-OR_2$ befinden. In besonders bevorzugten Harzen der Formel V bedeutet x entweder null, so dass $R^6$ fehlt, oder 1, wobei die Gruppen $R^6$ dann gleiche oder verschieden Alkylgruppen mit 1 bis 9 Kohlenstoffatomen oder eine Gruppe der Formel IV mit $R^8$ als Methylen- oder Isopropylidengruppe darstellen. Bei einer weiteren Alternative bedeutet x null für einen Teil der in der Formel V angegebenen aromatischen Ringe sowie 1 für den Rest der Ringe, wobei die Gruppen $R^6$ gleiche oder verschiedene Alkylgruppen mit 1 bis 9 Kohlenstoffatomen darstellen. Spezielle bevorzugte Alkylgruppen $R^6$ sind o-, m- und p-Methyl, o-, m- und p-tert.-Butyl sowie o-, m- und p-Octyl, wobei die Stellungen sich auf die Gruppen $-OR^2$ beziehen. Weitere besonders bevorzugte Harze der Formel V sind solche, worin x für einen Teil der angegebenen aromatischen Ringe 1 bedeutet und die Gruppen $R^6$ gleiche oder verschiedene Alkylgruppen mit 1 bis 9 Kohlenstoffatomen darstellen, und x für die übrigen aromatischen Ringe 2 bedeutet, wobei die beiden Gruppen $R^6$ sich in den 2,3-Stellungen bezüglich der angegebenen Gruppen $-OR^2$ befinden und die Gruppen $R^6$ zusammen mit den Kohlenstoffatomen, an die sie gebunden sind, eine unsubstituierte Benzogruppe darstellen.

Gegenstand der Erfindung ist ferner ein Verfahren zur Herstellung lichtempfindlicher modifizierter Phenolnovolakharze, welches dadurch gekennzeichnet ist, dass man (A) ein Phenolnovolakharz, hergerstellt aus einem Phenol (B) und einem Aldehyd (C), mit (D) einer Chinondiazidsulfonsäure oder einem reaktionsflähigen Derivat von dieser umsetzt und mindestens eines von (A), (B) und dem Reaktionsprodukt aus (A) und (D) weiter mit (E) einem Polycarbonsäureanhydrid der Formel

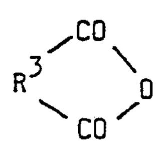

VI

worin $R^3$ die obigen Bedeutung hat innerhalb 2 bis 8 Stunden, zur Reaktion bringt, wobei die Chinondiazidsulfonsaüre oder deren Derivat (D) in einer Menge von mindestens 0,04 Mol, und das Anhydrid (E) en einer Menge von mindestens 0,01 Mol, 750 Aequivalent phenolische hydroxylgruppe im Novolach (A) oder im Phenol (B) eingeseht werden.

Das Verfahren wird vorzugsweise durch Umsetzung des Novolakharzes (A) mit der Chinondiazidsulfonsäure oder deren Derivat (D) und anschliessende Reaktion des erhaltenen Produkts mit dem Anhydrid (E) oder durch Umsetzung von (A) mit (E) und Reaktion des gebildeten Produkts mit (D) durchgeführt.

Die Chinondiazidsulfonsäure oder deren Derivat (D) wird in einer Menge von vorzugsweise 0,04 bis 0,75 Mol und insbesondere 0,10 bis 0,50 Mol sowie besonders bevorzugt 0,10 bis 0,25 Mol pro Aequivalent phenolische Hydroxylgruppe im Novolakharz (A) oder im Phenol (B) eingesetzt. Das Anhydrid (E) verwendet man in einer Menge von vorzugsweise 0,02 bis 0,5 Mol, insbesondere 0,04 bis 0,3 Mol und besonders bevorzugt 0,04 bis 0,2 Mol pro Aequivalent phenolische Hydroxylgruppe im Novolakharz (A) oder im Phenol (B).

Jegliche verbliebene phenolische Hydroxylgruppen werden vorzugsweise freigelassen. Gewünschtenfalls kann man sie jedoch mit (F) einem Veresterungsmittel, das von (D) verschieden ist, verestern oder mit einem Verätherungsmittel (G) veräthern. Diese Veresterung bzw. Verätherung kann dadurch erfolgen, dass man mindestens eines von dem Novolakharz (A), dem Reaktionsprodukt aus (A) mit (D), dem Reaktionsprodukt aus (A) mit (E) und dem Reaktionsprodukt aus (A), (D) und (E) mit (F) bzw. (G) umsetzt.

Das Novolakharz (A) kann von einem einzigen Phenol (B) oder einem Gemisch von Phenolen (B) stammen, die jeweils einwertig oder mehrwertig sein und einen oder mehrere aromatische Ringe besitzen können.

Bevorzugte Phenole (B) entsprechen der allgemeinen Formel

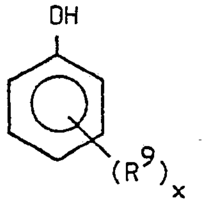

VII

worin x null, 1, 2 oder 3 bedeutet und $R^9$ die gleiche Bedeutung wie $R^6$ in Formel I oder V hat, mit der Massgabe, dass es keine Gruppe der Formel IV darstellen darf, aber stattdessen für eine Gruppe der Formel

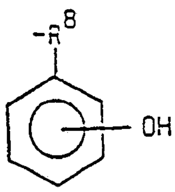

VIII

worin $R^8$ sowie bevorzugte Atome oder Gruppen $R^8$ die obigen Bedeutungen haben, stehen kann.

Bevorzugte Werte für x sind wie oben angegeben, bevorzugte Atome oder Gruppen $R^9$ sind dieselben wie die oben angegebenen bevorzugten Atome oder Gruppen $R^6$. Zu geeigneten Phenolen (B) zählen somit o-, m- und p-Chlorphenol, Resorcin, bis-(4-hydroxyphenyl)-methan, 4,4'-Dihydroxybenzophenon, 2,2-bis-(4-hydroxyphenyl)-essigsäure, 4,4-Bis-(4-hydroxyphenyl)-pentansäure, p-Hydroxybenzoesäure, 2-Naphthol, 4-Chlor-1-naphthol, 4-Methyl-2-naphthol, 1,5-und 1,7-Dihydroxynaphthalin sowie Gemische von zwei oder mehr dieser Phenole. Bevorzugte Phenole (B) sind Phenol selbst, o-, m- und p-Kresol, o-, m- und p-tert.-Butylphenol, o-, m- und p-Octylphenol, 1-Naphthol, 2,2-Bis-(4-hydroxyphenyl)-propan sowie Gewische von zwei oder mehreren dieser Phenole. In besonders bevorzugten Ausführungsformen ist (B) m-Kresol, ein Gemisch aus Phenol und p-tert.-Butylphenol, ein Gemisch aus o-, m- und p-Kresol, ein Gemisch aus 1-Naphthol und m- Kresol oder 2,2-Bis-(4-hydroxyphenyl)-propan.

Der Aldehyd (C), aus dem der Novolak (A) hergestellt wird, entspricht vorzugsweise der Formel

$R^1CHO$

IX worin $R^1$ und bevorzugte Atome und Gruppen $R^1$ die obigen Bedeutungen haben. Zu bevorzugten Aldehyden gehören somit Formaldehyd, Acetaldehyd, Propionaldehyd, Benzaldehyd und Glyoxylsäure, während Formaldehyd und Benzaldehyd besonders bevorzugt sind.

Die Reaktion zwischen dem Phenol (B) und dem Aldehyd (C) zur Bildung des Novolakharzes kann gemäss der herkömmlichen Praxis zur Herstellung von Novolaken erfolgen, wobei man das Phenol mit einem Moläquivalent oder weniger des Aldehyds in Gegenwart einer Säure erhitzt.

Das Chinondiazidderivat (D) entspricht vorzugsweise der Formel

$R^4SO_2Z$

worin $R^4$ und bevorzugte Gruppen $R^4$ die obigen Bedeutungen haben und Z für eine Hydroxylgruppe, eine Alkoxygruppe, vorzugsweise mit 1 bis 4 Kohlenstoffatomen, oder ein Halogenatom, insbesondere ein Chloratom, steht.

Vorzugsweise ist (D) 1,2-Naphthochinon-2-diazid-4-oder -5-sulfonylchlorid oder 1,2-Benzochinon-2-diazid-4-sulfonylchlorid. Die Umsetzung zwischen (D) und dem Phenolnovolak (A) bzw. zwischen (D) und dem Reaktionsprodukt des Phenolnovolaks (A) und des Anhydrids (E) wird üblicherweise in einem inerten Lösungsmittel, wie einem Keton oder Aether, bei Raumtemperatur und in Gegenwart eines geeigneten Kondensationsmittels, das eine Säure, wenn Z für eine Hydroxyl- oder Alkoxygruppe steht, oder eine Base, wenn Z für ein Halogenatom steht, sein kann, durchgeführt.

Bevorzugte und besonders bevorzugte Anhydride der Formel VI sind solche der oben als quelle der zweiwertigen Gruppe $R^3$ erwähnten Säuren. Besonders bevorzugte Anhydride sind also Glutarsäureanhydrid, Isooctenylbernsteinsäureanhydrid und Phthalsäureanhydrid.

Das fakultative Veresterungsmittel (F) ist gewöhnlich eine Carbonsäure oder Sulfonsäure oder deren Derivat, der Formel $R^5COZ$ oder $R^5SO_2Z$, worin $R^5$ und Z sowie bevorzugte Atome oder Gruppen $R^5$ und Z die obigen Bedeutungen haben. Zu bevorzugten solchen Veresterungsmitteln zählen Acetylchlorid, Benzoylchlorid, Methansulfonylchlorid, Benzolsulfonylchlorid und p-Toluolsulfonylchlorid.

Das fakultative Verätherungsmittel (G) kann ein herkömmliches Verätherungsmittel sein, beispielsweise ein Alkohol wie Methanol, Aethanol, Isopropanol, n-Butanol, Aethylenglykol, 2-Methoxyäthanol oder 2-Butoxyäthanol, ein Alkylenoxyd wie Aethylen- oder Propylenoxyd, ein Dialkylsulfat wie Dimethylsulfat oder ein Alkylhalogenid wie Methyljodid.

Die Umsetzung zwischen dem Anhydrid (E) und entweder dem Novolakharz (A) oder dem Reaktionsprodukt aus (A) und dem Chinondiazid (D) erfolgt üblicherweise in einem inerten Lösungsmittel wie einem Keton oder Aether, gegebenenfalls in Gegenwart einer Base oder eines quartären Ammoniumsalzes als Katalysator. Die Reaktion wird im allgemeinen bei einer Temperatur von 40°C bis 150°C durchgeführt und ist innerhalb 2 bis 8 Stunden vollständig.

Die fakultative Veresterungsstufe unter Verwendung des Veresterungsmittels (F) erfolgt üblicherweise in einem inerten Lösungsmittel, wie einem Keton oder Aether, bei Raumtemperatur und in Gegenwart eines geeigneten Kondensationsmittels, das eine starke Säure, wenn Z für eine Hydroxyl- oder Alkoxygruppe steht, oder eine Base, wenn Z für ein Halogenatom steht, sein kann. Die Menge (F) beträgt vorzugsweise nicht mehr als 0,4 Mol pro Aequivalent phenolisches Hydroxyl in (A).

Die fakultative Verätherungsstufe unter Verwendung von (G) kann man mittels herkömmlicher Methoden zur Verätherung von Phenolharzen durchführen, vorzugsweise unter Verwendung von nicht mehr als 0,4 Mol (G) pro Aequivalent phenolisches Hydroxyl in (A).

Es versteht sich, dass nach partieller Reaktion der phenolischen Hydroxylgruppen in einem Novolakharz mit einem oder mehreren Veresterungsmitteln das modifizierte Harz neben Molekülen, worin einige der aromatischen Ringe freie Hydroxylgruppen und die übrigen aromatischen Ringe veresterte Hydroxylgruppen aufweisen, sowohl Moleküle, wo sämtliche aromatischen Ringe freie Hydroxylgruppen besitzen, als auch Moleküle, worin sämtliche aromatischen Ringe veresterte Hydroxylgruppen tragen, enthalten wird. Solche Harze darstellende Formeln wie Formel V sind deshalb statistische Beschreibungen, in denen $R^2$ auf einigen Ringen Wasserstoffatome, Gruppen $SO_2R^4$ an anderen Ringen, Gruppen $-COR^3COOH$ an weiteren Ringen sowie Gruppen $-COR^5$ Oder $-SO_2R^5$ an noch weiteren Ringen bedeuten kann. Aehnliches gilt für Formel V, soweit diese von einem Gemisch verschiedener Phenole abgeleitete Harze darstellt.

Bei der Verwendung als galvanisch abscheidbare Photoresists werden die erfindungsgemässen Harze in Form von Salzen eingesetzt, die in wässrigen, einschliesslich wässrig-organischen Medien löslich oder dispergierbar sind. Wenn sie in Medien so hergestellt werden, dass sie als Salze vorliegen, so kann man die diese Salze enthaltenden Medien direkt für das galvanische Abscheidungsverfahren einsetzen. Werden die Harze als Säuren isoliert, so wandelt man sie vor dem Gebrauch im galvanischen Abscheidungsverfahren durch Zusatz einer geeigneten Base zur zumindest teilweisen Neutralisation der Säuregruppen in ihre Salze um.

Als geeignete Basen zur Salzbildung kommen dabei anorganische Basen wie Natrium- oder Kaliumhydroxyd oder -carbonat und Ammoniak sowie organische Basen wie Triäthylamin, Triäthanolamin, Benzyldimethylamin, Dimethyläthanolamin und Dimethylaminomethylpropanol in Betracht.

Bei der Verwendung als Photoresists kann man die Salze erfindungsgemässer Harze zur Bildung lichtempfindlicher Elemente auf Träger aufschichten. Als Träger kommen Metalle wie Aluminium und Kupfer entweder als solides Blech oder als metallkaschiertes Laminat in Frage.

Die erfindungsgemässen Harze lassen sich allein oder gewünschtenfalls als Gemisch mit Substanzen verwenden, die in wässrigen Medien löslich oder dispergierbar sind und die Güte der abgeschiedenen Beschichtung verbessern. Typische solche Substanzen sind unter anderem wasserverdünnbare Acryl-, Alkyd-, Polybutadien- und Epoxidharze.

Die galvanische Abscheidung der neuen Harze erfolgt nach bekannten Arbeitsweisen. Spannungen bis zu 200 Volt für Zeiträume von bis zu 5 Minuten werden im allgemeinen verwendet, aber die genauen Bedingungen für bestimmte Harze, Substrate und gewünschte Dicken sind leicht durch den Fachmann auf dem Gebiet der galvanischen Abscheidung von harzartigen Materialien bestimmbar.

Die galvanisch abgeschiedenen Beschichtungen werden getrocknet und können dann aktinischer Strahlung einer Wellenlänge von vorzugsweise 200 bis 600 nm ausgesetzt werden, üblicherweise durch ein bildtragendes Dia hindurch. Beim Entwickeln mit einer geeigneten wässrigen oder nichtwässrigen Base verbleibt eine positive Abbildung auf dem Substrat.

Gegenstand der Erfindung ist dementsprechend ferner ein Verfahren zur Erzeugung einer Abbildung, welches dadurch gekennzeichnet ist, dass man durch galvanische Abscheidung eine ein erfindungsgemässes Harz enthaltende Schicht auf ein Substrat aufbringt, die galvanisch abgeschiedene Schicht in einem vorbestimmten Muster mit aktinischer Strahlung belichtet und die belichteten Stellen durch Kontakt mit einem Entwickler entfernt.

Die nachfolgenden Beispiele veranschaulichen die Erfindung. Dabei sind Teile und Prozentangaben Gewichtsteile und Gewichtsprozente.

Die als Ausgangsmaterialien verwendeten Novolakharze sind wie folgt:

Novolak I

Dies bezeichnet ein Harz aus einem aus 3 Mol Phenol und 1 Mol p-tert.-Butylphenol sowie Formaldehyd durch weitere Umsetzung mit 1,2-Naphthochinon-2-diazid-5-sulfonylchlorid hergestellten Novolak. Das Produkt entspricht der Formel V, worin $R^1$ für Wasserstoff steht, 88% der Gruppen $R^2$ Wasserstoff und der Rest eine 1,2-Naphthochinon-2-diazid-5-sulfonylgruppe darstellen, x für 75% des Moleküls null und für 25% des Moleküls 1, wobei $R^6$ dann p-tert.-Butyl bedeutet, und n eine ganze Zahl vom Durchschnittswert 7,1 sind.

Novolak II

Dies bezeichnet einen aus Phenol, p-tert.-Butylphenol, Formaldehyd und Oxalsäure im Molverhältnis 0,75 : 0,25 : 0,90 : 0,046 hergestellten Novolak.

Der Novolak besitzt einen Erweichungspunkt von 119°C und entspricht der Formel V, worin $R^1$ für Wasserstoff und $R^2$ für Wasserstoff stehen, x für 75% des Moleküls null und für 25% des Moleküls 1, wobei $R^6$ dann p-tert.-Butyl bedeutet, und n eine ganze Zahl vom Durchschnittswert 7,5 sind.

Novolak III

Dies bezeichnet einen aus einem handelsüblichen Gemisch von o-, m- und p-Kresol, Formaldehyd und Oxalsaüre im Molverhältnis 1 : 0,75 : 0,001 hergestellten Novolak.

Der Novolak besitzt einen Erweichungspunkt von 120°C und entspricht der Formel V, worin $R^1$ und $R^2$ für Wasserstoff stehen sowie x 1, $R^6$ o-, m- und p-Methyl und n eine ganze Zahl vom Durchschnittswert 6,5 bedeuten.

Novolak IV

Dies bezeichnet einen aus 1-Naphthol, m-Kresol, Formaldehyd und Oxalsäure im Molverhältnis 0,2 : 0,8 : 0,9 : 0,017 hergestellten Novolak.

Der Novolak besitzt einen Erweichungspunkt von 148°C und entspricht der Formel V, worin $R^1$ und $R^2$ für Wasserstoff stehen sowie x für 80% des Moleküls 1, wobei $R^6$ dann m-Methyl darstellt, und für 20% des Moleküls 2, wobei die beiden Gruppen $R^6$ in den 2,3-Stellungen zu den Gruppen $-OR^2$ zusammen mit den Kohlenstoffatomen, an die sie gebunden sind, eine unsubstituierte Benzogruppe darstellen, und n eine ganze Zahl vom Durchschnittswert 4,8 sind.

Novolak V

Dies bezeichnet einen aus m-Kresol, Benzaldehyd und HC1 im Molverhältnis 1,00 : 1,00 : 0,005 hergestellten Novolak.

Der Novolak besitzt einen Erweichungspunkt von 118°C und entspricht der Formel V, worin $R^1$ für Phenyl, $R^2$ für Wasserstoff, x für 1, $R^6$ für m-Methyl und n für eine ganze Zahl vom Durchschnittswert 4,2 stehen.

Novolak VI

Dies bezeichnet einen aus Bisphenol A und Formaldehyd im Molverhältnis 1 : 0,46 unter Verwendung von Orthophosphorsäure als Katalysator hergestellten Novolak.

Der Novolak besitzt einen Erweichungspunkt von 75°C und entspricht der Formel V, worin $R^1$ and $R^2$ für Wasserstoff x für 1, $R^6$ für eine Gruppe der Formel IV, worin $R^8$ eine Isopropylidengruppe in para-Stellung zu beiden Gruppen $-OR^2$ bedeutet, und n für eine ganze Zahl vom Durchschnittswert 2,4 stehen.

Beispiel 1

Man löst Novolak I (20 g) in Aceton (50 g) und erhitzt auf 50°C, versetzt mit einer Lösung von Isooctenylbernsteinsäureanhydrid (4,4 g) und einer 0,5%igen wässrigen Lösung von Tetramethylammoniumchlorid (0,12 g) in Aceton (10 g) und erhitzt 8 Stunden lang auf 50°C. Das Gemisch wird in verdünnte Salzsäure (1000 g - 0,1% HC1) eingetropft, was zur Ausfällung eines braunen harzartigen Feststoffs führt. Dieser wird zu einem Pulver vermahlen, mit Wasser gewaschen und im Vakuumtrockenschrank bei 35°C getrocknet, wobei man 17,7 g eines Produkts der Formel V erhält, worin $R^1$ für Wasserstoff, 72,5% der Gruppen $R^2$ für Wasserstoff, 12% für eine 1,2-Naphthochinon-2-diazid-5-sulfonylgruppe und 15,5% für eine Gruppe der Formel

$$-CO-CH-CH_2COOH$$
$$CH=CH(CH_2)_3CH(CH_3)_2$$ XI

oder

$$-CO-CH_2-CH-COOH$$
$$CH=CH(CH_2)_3CH(CH_3)_2$$ XII

x bei 75% des Moleküls für null und bei 25% für 1, wobei $R^6$ dann p-tert.-Butyl bedeutet, und n für eine ganze Zahl vom Durchschnittswert 7,1 stehen.

Das an einem KBr-Pressling gemessene Infrarotspektrum zeigt Absorptionsmaxima bei 3400, 2960, 2860, 2160, 2120, 1710, 1660, 1500, 1480, 1440, 1400, 1360, 1260 und 1200 $cm^{-1}$.

Dieses Produkt gibt man langsam zu einem Gemisch aus 2-Butoxyäthanol (4 g) und einer 20%igen wässrigen Lösung von Kaliumhydroxyd (0,5 g), wobei man eine rotbraune Lösung erhält, die mit Wasser auf 10% Produktgehalt weiter verdünnt wird. Dieses Produkt wird unter Verwendung einer Edelstahlkathode auf einer kupferkaschierten Laminatanode galvanisch abgeschieden. Eine 5 Mikrometer dicke Auflage bildet sich nach 20 Sekunden bei 80 Volt. Das Laminat wird aus dem Bad entnommen, mit Wasser gespült und 5 Minuten lang bei 90°C getrocknet. Dann bestrahlt man es durch ein bildtragendes Dia hindurch 1 Minute lang unter Verwendung einer 5000 W-Mitteldruckquecksilberhalogenidlampe in 75 cm Abstand. Eintauchen in 0,5%ige wässrige Natronlauge ergibt eine klare positive Abbildung des Dias.

Beispiel 2

Man löst Novolak 1 (30 g) in Aceton (60 g) und erhitzt zum Rückfluss (59°C), versetzt mit einer Lösung von Phthalsäureanhydrid (4,4 g), Triäthylamin (0,17 g) und Aceton (10 g) und hält 2 Stunden lang am Rückfluss. Das Gemisch wird mit einer 20%igen wässrigen Lösung von Natriumhydroxyd (6 g) neutralisiert und mit Wasser (150 g) verdünnt. Zusatz dieses Gemischs zu 1000 $cm^3$ HC1 (6 g) enthaltendem Wasser führt zur Ausfällung eines gelbbraunen harzartigen Feststoffs. Dieser wird mit Wasser gewaschen und im Vakuumtrockenschrank bei 35°C getrocknet, wobei man 30,2 g eines Produkts der Formel V erhält, worin $R^1$ für Wasserstoff, 73% der Gruppen $R^2$ für Wasserstoff, 12% für eine 1,2-Naphthochinon-2-diazid-5-sulfonylgruppe und 15% für eine Gruppe der Formel

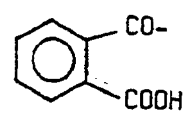

XIII

x bei 75% des Moleküls für null, bei 25% des Moleküls für 1, wobei $R^6$ dann p-tert.-Butyl bedeutet, und n für eine ganze Zahl vom Durchschnittswert 7,1 stehen.

Sein an einem KBr-Pressling gemessenes Infrarotspektrum zeigt Absorptionsmaxima bei 3400, 2960, 2860, 2160, 2120, 1710, 1600, 1510, 1490, 1430, 1400, 1360, 1260 und 1190 $cm^{-1}$.

Dieses Produkt kann galvanisch auf ein Substrat abgeschieden und eine positive Abbildung erzeugt werden, wie in Beispiel 1 beschrieben.

Beispiel 3

Man wiederholt Beispiel 2, jedoch unter Ersatz des dort verwendeten Phthalsäureanhydrids durch Glutarsäureanhydrid (2,28 g). Dabei erhält man ein Produkt (19,0 g) mit einem an einem KBr-Pressling gemessenen Infrarotspektrum, das Absorptionsmaxima bei 3400, 3250, 2960, 2160, 2120, 1740, 1710, 1610, 1600, 1510, 1490, 1460, 1440, 1400, 1360, 1260 und 1200 $cm^{-1}$ zeigt.

Das Produkt entspricht der Formel V, worin $R^1$ für Wasserstoff, 78% der Gruppen $R^2$ für Wasserstoff, 12% für eine 1,2-Naphthochinon-2-diazid-5-sulfonylgruppe und 10% für eine Gruppe der Formel $-CO(CH2)_3COOH$, x bei 75% des Moleküls für null und bei 25% für 1, wobei $R^6$ dann p-tert.-Butyl bedeutet, und n für eine ganze Zahl vom Durchschnittswert 7,1 stehen.

Das Produkt kann galvanisch auf ein Substrat abgeschieden und eine positive Abbildung erzeugt werden, wie in Beispiel 1 beschrieben.

Beispiel 4

Man löst Novolak II (25 g) in Dioxan (50 g) und erhitzt auf 100°C, versetzt mit Isooctenylbernsteinsäureanhydrid (5,5 g) und Tetramethylammoniumchlorid (0,3 g; 10%ige wässrige Lösung) und erhitzt 6 Stunden lang auf 100°C. Das Gemisch wird auf Raumtemperatur abgekühlt und dann in 0,1%ge wässrige Salzsäure (1000 $cm^3$) eingetropft. Das so erhaltene rote harzartige Produkt wird vermahlen und bei 90°C im Vakuumtrockenschrank getrocknet.

Man löst dieses Produkt (18 g) in Aceton (50 g) und versetzt mit einer Lösung von 1,2-Naphthochinon-2-diazid-5-sulfonylchlorid (6 g) in Aceton (20 g). Die Lösung wird durch Zugabe 10%iger wässriger Natriumcarbonatlösung auf pH 8 eingestellt. Man rührt das Gemisch 1 Stunde lang bei Raumtemperatur und tropft es dann in 0,2 N-Salzsäurelösung (2,5 Liter).

Dabei erhält man einen gelben harzartigen Niederschlag, und dieser wird abfiltriert, mit Wasser gewaschen und im Vakuumtrockenschrank bei 35°C zu einem Produkt (17,5 g) getrocknet, das ein ähnliches Infrarotabsorptionsspektrum wie das Produkt aus Beispiel 1 aufweist. Das Produkt kann galvanisch auf ein Substrat abgeschieden und eine positive Abbildung erzeugt werden, wie in Beispiel 1 beschrieben. Das Produkt entspricht der Formel V, worin $R^1$ für Wasserstoff, 68% der Gruppen $R^2$ für Wasserstoff, 19,5% für eine 1,2-Naphthochinon-2-diazid-5-sulfonylgruppe und 12,5% für eine Gruppe der Formel XI oder XII, x bei 75% des Moleküls für null und bei 25% für 1, wobei $R^6$ dann p-tert.-Butyl bedeutet, und n für eine ganze Zahl vom Durchschnittswert 7,5 stehen.

Beispiel 5

Man löst Novolak II (60 g) in Dioxan (120 g) und erhitzt auf 100°C, versetzt mit Glutarsäureanhydrid (6,84 g) und erhitzt 6 Stunden lang auf 100°C. Das Gemisch wird mit 20%igem wässrigem Natriumhydroxyd (12 g) neutralisiert, mit Wasser (400 g) verdünnt und in 0,3 N-Salzsäurelösung (1,5 Liter) eingetropft. Der gebildete gelbe Niederschlag wird abfiltriert, gewaschen und bei 90°C im Vakuumtrockenschrank getrocknet.

Man löst dieses Produkt (18 g) in Aceton (50 g) und versetzt mit einer Lösung von 1,2-Naphthochinon-2-diazid-5-sulfonylchlorid (6 g) in Aceton (20 g). Die Lösung wird durch Zugabe 10%iger wässriger Natriumcarbonatlösung auf pH 8 eingestellt. Man rührt das Gemisch 1 Stunde lang bei Raumtemperatur und tropft es dann in 0,2 N -HCl (2 Liter) ein.

Dabei bildet sich ein gelber Niederschlag, der abfiltriert, gewaschen und bei 35°C im Vakuumtrockenschrank getrocknet wird. Dabei erhält man ein Produkt (18 g), das ein ähnliches Infrarotabsorptionsspektrum wie für das Produkt aus Beispiel 3 aufweist. Es kann galvanisch auf ein Substrat abgeschieden und eine positive Abbildung erzeugt werden, wie in Beispiel 1 beschrieben. Das Produkt entspricht der Formel V, worin $R^1$ für Wasserstoff, 69,5% der Gruppen $R^2$ für Wasserstoff, 18% für eine 1,2-Naphthochinon-2-diazid-5-sulfonylgruppe und 12,5% für eine Gruppe der Formel $-CO(CH_2)_3COOH$, x bei 75% des Moleküls für null und bei 25% für 1, wobei $R^6$ dann p-tert.-Butyl bedeutet, und n für eine ganze Zahl vom Durchschnittswert 7,5 stehen.

Beispiel 6

Man wiederholt Beispiel 3, jedoch unter Verwendung von 0,86 g Glutarsäureanhydrid anstelle der dort eingesetzten 2,28 g. Das dabei erhaltene Produkt (24 g) entspricht der Formel V, worin $R^1$ für Wasserstoff, 84% der Gruppen $R^2$ für Wasserstoff, 12% für eine 1,2-Naphthochinon-2-diazid-5-sulfonylgruppe und 4% für eine Gruppe der Formel $-CO(CH_2)_3COOH$, x bei 75% des Moleküls für null und bei 25% für 1, wobei $R^6$ dann p-tert.-Butyl bedeutet, und n für eine ganze Zahl vom Durchschnittswert 7,1 stehen.

Das Produkt kann galvanisch auf ein Substrat abgeschieden und eine positive Abbildung erzeugt werden, wie in Beispiel 1 beschrieben.

Beispiel 7

Man löst Novolak III (22,5 g) in Aceton (50 g) und behandelt mit einer Lösung von 1,2-Naphthochinon-2-diazid-5-sulfonylchlorid (7,5 g) in Aceton (30 g). Das Gemisch wird durch Zugabe einer 5%igen Natriumcarbonatlösung in Wasser auf pH 8 eingestellt, dann 90 Minuten lang bei Raumtemperatur gerührt und in 1500 $cm^3$, HCl (12 g) enthaltendes Wasser gegossen, und der Niederschlag wird abfiltriert, mit Wasser gewaschen und im Vakuumtrockenschrank bei 35°C getrocknet, wobei man 26 g Feststoff erhält.

Diesen (10 g) löst man in Dioxan (20 g) und behandelt mit einer Lösung von Glutarsäureanhydrid (1,14 g) und Triäthylamin (0,06 g) in Dioxan (10 g). Man erhitzt auf 60°C und hält 2 Stunden lang bei dieser Temperatur. Das Gemisch wird mit 20%igen wässrigem Natriumhydroxyd (2 g) neutralisiert, mit Wasser (50 g) verdünnt und in 0,3 N-Salzsäure (1,5 Liter) eingetropft. Dabei bildet sich ein gelber Niederschlag, der abfiltriert, mit Wasser gewaschen und im Vakuumtrockenschrank bei 35°C getrocknet wird, wobei man 9,3 g eines Produkts der Formel V erhält, worin $R^1$ für Wasserstoff, 69% der Gruppen $R^2$ für Wasserstoff, 15% für eine 1,2-Naphthochinon-2-diazid-5-sulfonylgruppe und 16% für eine Gruppe der Formel $-CO(CH_2)_3COOH$, x für 1, $R^6$ für o-, m- und p-Methyl sowie n für eine ganze Zahl vom Durchschnittswert 6,5 stehen.

Das Produkt kann galvanisch auf ein Substrat abgeschieden und eine positive Abbildung erzeugt werden, wie in Beispiel 1 beschrieben.

Beispiel 8

Man löst Novolak IV (36 g) in Aceton (80 g) und behandelt mit einer Lösung von 1,2-Naphthochinon-2-diazid-5-sulfonylchlorid (12 g) in Aceton (20 g). Das Gemisch wird durch Zugabe von 5%igem wässrigem Natriumcarbonat auf pH 8 eingestellt, dann 90 Minuten lang bei Raumtemperatur gerührt und in HCl (17 g) enthaltendes Wasser (2 Liter) gegossen, und der Niederschlag wird abfiltriert, mit Wasser gewaschen und im Vakuumtrockenschrank bei 35°C getrocknet, wobei man 42,2 g Feststoff erhält.

Diesen Feststoff (10 g) löst man in Aceton (20 g), erhitzt zum Rückfluss (57°C), versetzt mit einer Lösung von Glutarsäureanhydrid (0,43 g), Triäthylamin (0,06 g) und Aceton (10 g) und hält 2 Stunden unter Rückfluss. Das Gemisch wird mit 20%iger wässriger Natronlauge neutralisiert und mit Wasser verdünnt. Die Zugabe dieses Gemischs zu 1000 $cm^3$, HCl (5 g) enthaltendem Wasser führt zur Ausfällung eines braunen harzartigen Feststoffs. Dieser wird mit Wasser gewaschen und im Vakuumtrockenschrank bei 35°C getrocknet, wobei man 8 g eines Produkts der Formel V erhält, worin $R^1$ für Wasserstoff, 77,6% der Gruppen $R^2$ für Wasserstoff, 16% für eine 1,2-Naphthochinon-2-diazid-5-sulfonylgruppe und 6,4% für eine Gruppe der Formel $-CO(CH_2)_3COOH$, x bei 80% des Moleküls für 1, wobei $R^6$ dann m-Methyl bedeutet, bei 20% für 2, wobei die beiden Gruppen $R^6$ in den 2,3-Stellungen zu den Gruppen $-OR^2$ zusammen mit den Kohlenstoffatomen, an die sie gebunden sind, eine unsubstituierte Benzogruppe bedeuten, und n für eine ganze Zahl vom Durchschnittswert 4,8 stehen.

Das Produkt kann galvanisch auf ein Substrat abgeschieden und eine positive Abbildung erzeugt werden, wie in Beispiel 1 beschrieben.

Beispiel 9

Man löst Novolak V (36 g) in Aceton (70 g) und behandelt mit einer Lösung von 1,2-Naphthochinon-2-diazid-5-sulfonylchlorid (12 g) in Aceton (30 g). Das Gemisch wird durch Zugabe 5%igen wässrigen Natriumcarbonats auf pH 8 eingestellt, dann 90 Minuten lang bei Raumtemperatur gerührt, und in HCl (17,6 g) enthaltendes Wasser (2 Liter) gegossen, und der Niederschlag wird abfiltriert, mit Wasser gewaschen und im Vakuumtrockenschrank bei 35°C getrocknet, wobei man 36,8 g Feststoff erhält.

Diesen Feststoff (10 g) löst man in Triäthylamin (0,06 g) enthaltendem Dioxan (20 g) und erhitzt auf 60°C, versetzt mit einer Lösung von Glutarsäureanhydrid (1,14 g) in Dioxan (20 g) und hält dann 3 Stunden lang bei 60°C. Das Gemisch wird mit einer 20%igen wässrigen Lösung von Natriumhydroxyd (2 g) neutralisiert und mit Wasser (50 g) verdünnt. Die Zugabe dieses Gemischs zu 500 $cm^3$, HCl (2 g) enthaltendem Wasser führt zur Ausfällung eines gelben harzartigen Feststoffs. Dieser wird mit Wasser gewaschen und im Vakuumtrockenschrank bei 35°C getrocknet, wobei man 8,7 g Produkt der Formel V erhält, worin $R^1$ für Phenyl, 50% der Gruppen $R^2$ für Wasserstoff, 25% für eine 1,2-Naphthochinon-2-diazid-5-sulphonylgruppe und 25% für eine Gruppe der Formel $-CO(CH_2)_3COOH$, x für 1, $R^6$ für m-Methyl und n für eine ganze Zahl vom Durchschnittswert 4,2 stehen.

Dieses Produkt kann galvanisch auf ein Substrat abgeschieden und eine positive Abbildung erzeugt werden, wie in Beispiel 1 beschrieben.

Beispiel 10

Man löst Novolak VI (60 g) in Aceton (120 g) und behandelt mit einer Lösung von 1,2-Naphthochinon-2-diazid-5-sulfonylchlorid (20 g) in Aceton (30 g). Das Gemisch wird durch Zugabe 5%igen wässrigen Natriumcarbonats auf pH 8 eingestellt, dann 90 Minuten lang bei Raumtemperatur gerührt und anschliessend in HCl (29 g) enthaltendes Wasser (3 Liter) gegossen, und der Niederschlag wird abfiltriert, mit Wasser gewaschen und im Vakuumtrockenschrank bei 35°C getrocknet, wobei man 62,3 g Feststoff erhält.

Diesen Feststoff (10 g) löst man in Triäthylamin (0,06 g) enthaltendem Dioxan (20 g), erhitzt auf 60°C, versetzt mit einer Lösung von Glutarsäureanhydrid (1,14 g) in Dioxan (20 g) und hält 2 Stunden lang bei 60°C. Das Gemisch wird mit einer 20%igen wässrigen Lösung von Natriumhydroxyd (2 g) neutralisiert und mit Wasser (50 g) verdünnt. Zugabe dieses Gemischs zu 500 cm³, HCl (2 g) enthaltendem Wasser führt zur Ausfällung eines rotbraunen harzartigen Feststoffs. Dieser wird mit Wasser gewaschen und im Vakuumtrokkenschrank bei 35°C getrocknet, wobei man 8,7 g Produkt der Formel V erhält, worin $R^1$ für Wasserstoff, 69% der Gruppen $R^2$ für Wasserstoff, 15% für eine 1,2-Naphthochinon-2-diazid-5-sulfonylgruppe und 16% für eine Gruppe der Formel $-CO(CH_2)_3COOH$, $R^6$ für eine Gruppe der Formel IV, worin $R^8$ eine Isopropylidengruppe in para-Stellung zu beiden Gruppen $OR^2$ bedeutet, x für 1 und n für eine ganze Zahl vom Durchschnittswert 2,4 stehen.

Dieses Produkt kann galvanisch auf ein Substrat abgeschieden und eine positive Abbildung erzeugt werden, wie in Beispiel 1 beschrieben.

**Patentansprüche**

1. Zumindest teilweise in Form von Salzen vorliegende galvanisch abscheidbare, lichtempfindliche modi fizierte Phenolnovolakharze der allgemeinen Formel

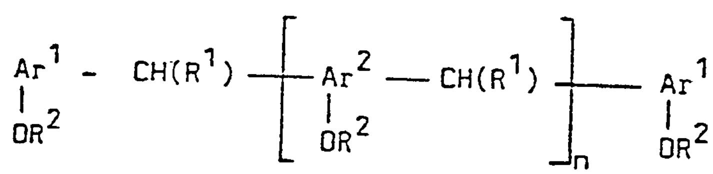

I

worin $Ar^1$ für eine über aromatische Kohlenstoffatome an die angegebenen Gruppen $-OR^2$ und $-CH(R^1)-$ gebundene zweiwertige aromatische Gruppe, $Ar^2$ für eine über aromatische Kohlenstoffatome an die angegebenen Gruppen $-OR^2$ und $-CH(R^1)-$ gebundene dreiwertige aromatische Gruppe, $R^1$ für ein Wasserstoffatom oder eine Alkyl-, Aryl- oder Carboxylgruppe, $R^2$ für ein Wasserstoffatom, eine gegebenenfalls durch eine Hydroxyl- oder Alkoxygruppe substituierte Alkylgruppe oder eine Gruppe der Formel $-CO-R^3-COOH$, $-SO_2R^4$, $-COR^5$ oder $-SO_2R^5$, wobei mindestens 1% der Gruppen $R^2$ eine Gruppe $-CO-R^3-COOH$ und mindestens 4% der Gruppen $R^2$ eine Gruppe $-SO_2R^4$ bedeuten, wobei $R^3$ eine zweiwertige aliphatische, cycloaliphatische, aromatische oder araliphatische Gruppe, $R^4$ eine 1,2-Benzochinondiazidgruppe bzw. 1,2-Naphthochinondiazidgruppe der Formel

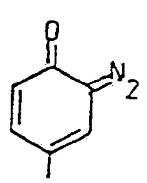

bzw.

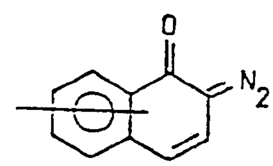

II

III

wobei sich die freie Valenzbindung der Formel III in 4-oder 5-Stellung befindet, $R^5$ eine carboxylfreie, einwertige aliphatische, cycloaliphatische, aromatische oder araliphatische Gruppe bedeutet und n für null oder eine ganze Zahl von 1 bis 20 stehen.

2. Harze nach Anspruch 1, dadurch gekennzeichnet, dass die Gruppen $Ar^1$ und $Ar^2$ 6 bis 25 Kohlenstoffatome besitzen und gegebenenfalls an einem aromatischen Kohlenstoffatom einen Substituenten $R^6$ tragen, wobei $R^6$ für ein Halogenatom, eine Gruppe der Formel $-OR^2$, eine gegebenenfalls veresterte Carboxyl- oder Sulfonsäuregruppe, eine gegebenenfalls durch eine Hydroxyl- oder Carboxylgruppe substituierte Alkyl-, Alkenyl- oder Arylgruppe oder eine Gruppe der Formel $-COR^7$ steht, worin $R^7$ eine Alkyl-, Cycloalkyl- oder Arylgruppe bedeutet, oder je eine Gruppe an jedem aromatischen Ring eine Gruppe der Formel

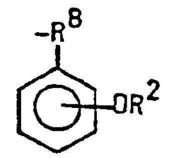

IV

darstellen kann, die gegebenenfalls mit benachbarten aromatischen Ringen über Gruppen -CH($R^1$)- verknüpft ist, wobei $R^8$ für ein Sauerstoff- oder Schwefelatom, eine Carbonyl-oder Sulfonylgruppe oder eine gegebenenfalls durch ein Halogenatom, eine gegebenenfalls verätherte Hydroxylgruppe, eine gegebenenfalls veresterte Carboxylgruppe oder eine gegebenenfalls durch ein Halogenatom oder eine gegebenenfalls verätherte Hydroxylgruppe oder gegebenenfalls veresterte Carboxylgruppe substituierte Arylgruppe mit 6 bis 12 Kohlenstoffatomen substituierte Alkylengruppe mit 1 bis 8 Kohlenstoffatomen steht, oder, falls zwei Substituenten $R^6$ an benachbarten Kohlenstoffatomen vorliegen, die beiden Substituenten $R^6$ zusammen mit den Kohlenstoffatomen, an die sie gebunden sind, eine Benzogruppe darstellen.

3. Harze nach Anspruch 1 oder 2, gekennzeichnet durch die allgemeine Formel

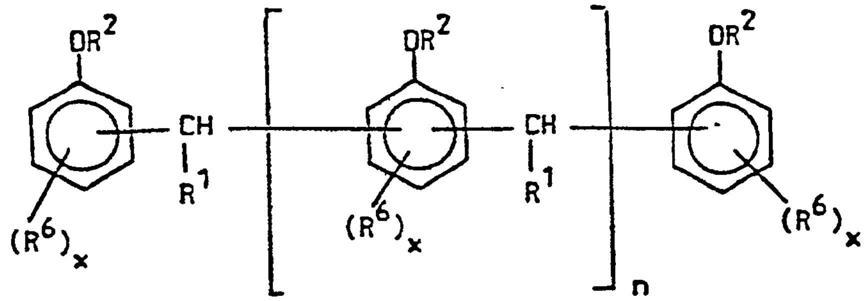

V

worin $R^1$, $R^2$ und n die in Anspruch 1 und $R^6$ die in Anspruch 2 angegebenen Bedeutungen haben und x null, 1, 2 oder 3 ist.

4. Harze nach Anspruch 1, 2 oder 3, dadurch gekennzeichnet, dass 8 bis 75% der Gruppen $R^2$ eine Gruppe der Formel $-SO_2R^4$ sowie 2 bis 50% eine Gruppe der Formel $-CO-R^3-COOH$ darstellen.

5. Harze nach einem der vorhergehenden Ansprüche, dadurch gekennzeichnet, dass Alkyl-, Alkoxy- und Alkenylgruppen unter den Definition für $R^1$, $R^2$, $R^6$ und $R^7$ bis zu 20 Kohlenstoffatome, Aryl- und Aralkylgruppen unter den definitionen für $R^1$, $R^6$ und $R^7$ bis zu 20 Kohlenstoffatome und einwertige Gruppen unter der Definition für $R^5$ sowie zweiwertige Gruppen unter der Definition für $R^3$ bis zu 25 Kohlenstoffatome aufweisen.

6. Harze nach einem der vorhergehenden Ansprüche, dadurch gekennzeichnet, dass $R^1$ für ein Wasserstoffatom oder für eine Methyl-, Aethyl-, Phenyl- oder Carboxylgruppe steht.

7. Harze nach einem der vorhergehenden Ansprüche, dadurch gekennzeichnet, dass $R^3$ für eine zweiwertige, gegebenenfalls durch ein oder mehrere Halogenatome, Alkoxygruppen mit 1 bis 4 Kohlenstoffatomen oder gegebenenfalls veresterte Carboxylgruppen substituierte Kohlenwasserstoffgruppe steht.

8. Harze nach Anspruch 7, dadurch gekennzeichnet, dass $R^3$ den Rest einer aliphatischen, cycloaliphatischen oder aromatischen Polycarbonsaüre mit 4 bis 20 Kohlenstoffatomen nach Wegnahme von zwei Carboxylgruppen darstellt.

9. Harze nach einem der Ansprüche 3 bis 8, dadurch gekennzeichet, dass x null bedeutet oder x 1 bedeutet und die Gruppen $R^6$ gleiche oder verschiedene Alkylgruppen mit 1 bis 9 Kohlenstoffatomen oder eine Gruppe der Formel IV darstellt, worin $R^8$ für eine Methylen- oder Isopropylidengruppe steht, oder x für einen Teil der angegebenen aromatischen Ringe null und für den Rest 1 bedeutet und die Gruppen $R^6$ gleiche oder verschidene Alkylgruppen mit 1 bis 9 Kohlenstoffatomen darstellen oder x für einen Teil der angegebenen aromatischen Ringe 1 bedeutet, wobei die Gruppen $R^6$ gleiche oder verschiedene Alkylgruppen mit 1 bis 9 Kohlenstoffatomen darstellen, und für die übrigen Ringe 2 bedeutet, wobei die beiden Gruppen $R^6$ sich in den 2,3-Stellungen zu den angegebenen Gruppen $-OR^2$ befinden und die Gruppen $R^6$ zusammen mit den Kohlenstoffatomen, an die sie gebunden sind, eine unsubstituierte Benzogruppe darstellen.

10. Salze von Halzen nach einem der vorhergehenden Ansprüche, dadurch gekennzeichnet, dass sie in wässrigem Medium löslich oder dispergierbar sind.

11. Verfahren zur Herstellung lichtempfindlicher modifizierter Phenolnovolakharze, dadurch gekennzeichnet, dass man (A) ein Phenolnovolakharz, hergestellt aus einem Phenol (B) und einem Aldehyd (C), mit (D) einer Chinondiazidsulfonsäure oder einem reaktionsfähigen Derivat von dieser umsetzt und mindestens eines von (A), (B) und dem Reaktionsprodukt aus (A) und (D) weiter mit (E) einem Polycarbonsäureanhydrid der For-

mel

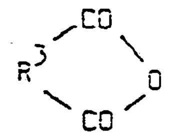

VI

worin $R^3$ die in Anspruch 1 angegebene Bedeutung hat, zur Reaktion bringt, wobei die Chinon diazidsulfonsaüre oder deren Derivat (D) in einer Menge von mindestens 0,04 Mol, und as Anhydrid (E) in einer Menge von mindestens 0,01 Mol, pro Aequivalent phenolische Hydroxylgruppe im Novolach (A) oder im Phenol (B) eingesetzt werden.

12. Verfahren nach Anspruch 11, dadurch gekennzeichnet, dass das Phenol (B) der Formel

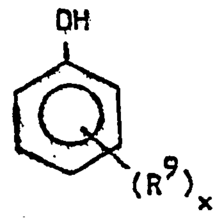

VII

der Aldehyd (C) der Formel $R^1CHO$ und das Chinondiazid (D) der Formel $R^4SO_2Z$ entsprechen, wobei $R^1$ und $R^4$ die in Anspruch 1 angegebene Bedeutung haben, $R^9$ dieselbe Bedeutung wie $R^6$ in Formel I hat, mit der Massgabe, dass es anstelle einer Gruppe der Formel IV eine Gruppe der Formel

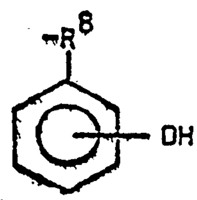

VIII

worin $R^8$ die in Anspruch 2 angegebene Bedeutung hat, darstellen kann, und Z für eine Hydroxyl- oder Alkoxygruppe oder ein Halogenatom und x für null, 1, 2 oder 3 stehen.

13. Verfahren nach Anspruch 11 oder 12, dadurch gekennzeichnet, dass die Menge an (D) 0,04 bis 0,75 Mol pro Aequivalent phenolische Hydroxylgruppe in (A) und die Menge an (E) 0,02 bis 0,5 Mol pro Aequivalent phenolische Hydroxylgruppe in (A) beträgt und dass die Reaktion zwischen (E) und (A) bzw. (E) und dem Reaktionsprodukt aus (A) und (D) in einem inerten Lösungsmittel bei einer Temperatur von 40 bis 150°C erfolgt.

14. Verfahren zur Erzeugung einer Abbildung, dadurch gekennzeichnet, dass man durch galvanische Abscheidung eine ein Harz nach einem der Ansprüche 1 bis 10 enthaltende Schicht auf ein Substrat aufbringt, die galvanisch abgeschiedene Schicht in vorbestimmtem Muster aktinischer Strahlung aussetzt und belichtete Stellen durch Kontakt mit einem Entwickler entfernt.

## Claims

1. An electrodepositable photosensitive modified phenolic novolak resin of which at least part is in the form of a salt, of general formula

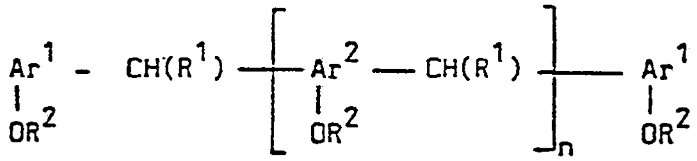

I

in which $Ar^1$ represents a divalent aromatic group linked through aromatic carbon atoms to the indicated groups $-OR^2$ and $-CH(R^1)-Ar^2$ represents a trivalent aromatic group linked through aromatic carbon atoms to the indicated groups $-OR^2$ and $-CH(R^1)-$, $R^1$ represents a hydrogen atom or an alkyl, aryl or carboxyl group, $R^2$ represents a hydrogen atom, an alkyl group which may be substituted by a hydroxyl or alkoxy group, or a group of formula $-CO-R^3-COOH$, $-SO_2R^4$, $-COR^5$ or $-SO_2R^5$, at least 1% of the groups $R^2$ representing a group $-CO-R^3-COOH$ and at least 4% of the groups $R^2$ representing a group $-SO_2R^4$, $R^3$ denotes a divalent aliphatic, cycloaliphatic, aromatic or araliphatic group, $R^4$ denotes a 1,2-diazobenzoquinone group or 1,2-diazonaphthoquinone group of formula

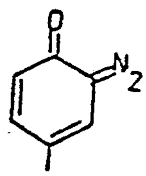

II

or

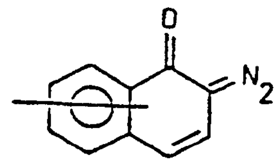

III

the free valency bond of formula III being in the 4- or 5- position, $R^5$ represents a carboxyl-free monovalent aliphatic, cycloaliphatic, aromatic or araliphatic group, and n denotes zero or an integer from 1 to 20.

2. A resin according to claim 1, in which the groups $Ar^1$ and $Ar^2$ have from 6 to 25 carbon atoms and optionally have a substituent $R^5$ on an aromatic carbon atom, where $R^6$ represents a halogen atom, a group of formula $-OR^2$, an optionally esterified carboxyl or sulphonic acid group, an alkyl, alkenyl or aryl group which may be substituted by a hydroxyl or carboxyl group, or a group of formula $-COR^7$ in which $R^7$ represents an alkyl, cycloalkyl or aryl group, or one group on each aromatic ring may represent a group of formula

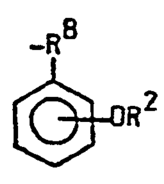

IV

which may be connected to adjacent aromatic rings through groups $-CH(R^1)-$, where $R^8$ represents an oxygen or sulphur atom, a carbonyl or sulphonyl group, or an alkylene group of 1 to 8 carbon atoms optionally substituted by a halogen atom, by a hydroxyl group which may be etherified, by a carboxyl group which may be esterified, or by an aryl group of 6 to 12 carbon atoms which may be substituted by a halogen atom or an optionally etherified hydroxyl group or an optionally esterified carboxyl group or, when there are two substituents $R^6$ on adjacent carbon atoms, the two substituents $R^6$, together with the carbon atoms to which they are attached, represent a benzo group.

3. A resin according to claim 1 or 2, which is of general formula

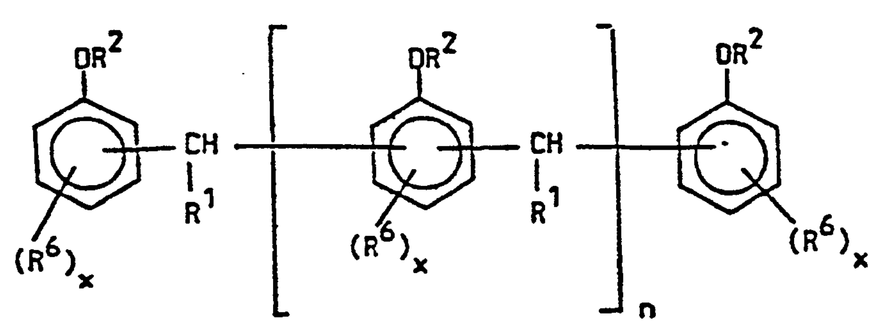

V

in which $R^1$, $R^2$ and n are as defined in claim 1 and $R^6$ is as defined in claim 2, and x denotes zero, 1, 2 or 3.

4. A resin according to claim 1, 2 or 3, in which 8 to 75% of the groups $R^2$ represent a group of formula $-SO_2R^4$, and 2 to 50% represent a group of formula $-CO-R^3-COOH$.

5. A resin according to any of the preceding claims, in which alkyl, alkoxy and alkenyl groups within the definitions of $R^1$, $R^2$, $R^6$ and $R^7$ have up to 20 carbon atoms, aryl and aralkyl groups within the definitions of $R^1$, $R^6$ and $R^7$ have up to 20 carbon atoms, and monovalent groups within the definition of $R^5$ and divalent groups within the definition of $R^3$ have up to 25 carbon atoms.

6. A resin according to any of the preceding claims, in which $R^1$ represents a hydrogen atom or a methyl, ethyl, phenyl or carboxyl group.

7. A resin according to any of the preceding claims, in which $R^3$ represents a divalent hydrocarbon group which may be substituted by one or more halogen atoms, alkoxy groups having 1 to 4 carbon atoms or carboxyl groups which may be esterified.

8. A resin according to claim 7, in which $R^3$ is the residue of an aliphatic, cycloaliphatic or aromatic polycarboxylic acid having 4 to 20 carbon atoms after the removal of two carboxyl groups.

9. A resin according to any of claims 3 to 8, in which x denotes zero, or x denotes 1 and the groups $R^6$ represent the same or different alkyl groups having 1 to 9 carbon atoms, or a group of formula IV where $R^8$ represents a methylene or isopropylidene group, or x denotes zero for some of the indicated aromatic rings and denotes 1 for the remainder, and the groups $R^6$ represent the same or different alkyl groups having 1 to 9 carbon atoms or x denotes 1 for some of the indicated aromatic rings, the groups $R^6$ representing the same or different alkyl groups having 1 to 9 carbon atoms, and denotes 2 for the remaining rings, the two groups $R^6$ being in the 2,3-positions with respect to the indicated groups $-OR^2$, and the groups $R^6$, together with the carbon atoms to which they are attached, representing an unsubstituted benzo group.

10. A salt of a resin according to any of the preceding claims, which is soluble or dispersible in aqueous medium.

11. A process for the preparation of photosensitive modified phenolic novolak resins, which comprises reacting (A) a phenolic novolak resin, prepared from a phenol (B) and an aldehyde (C), with (D) a diazoquinonesulphonic acid or a reactive derivative thereof, at least one of (A), (B) and the reaction product of (A) and (D) being further reacted within 2 to 8 hours with (E) a polycarboxylic acid anhydride of formula

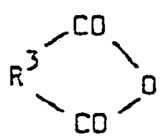

VI

in which $R^3$ is as defined in claim 1, and the diazoquinonesulphonic acid or its derivative (D) being used in an amount of at least 0.04 mole, and the anhydride (E) in an amount of at least 0.01 mole, per equivalent of phenolic hydroxyl group in the novolak (A) or in the phenol (B).

12. A process according to claim 11, in which the phenol (B) is of formula

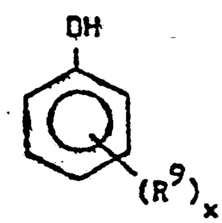

VII

the aldehyde (C) is of formula $R^1CHO$, and the diazoquinone (D) is of formula $R^4SO_2Z$, where $R^1$ and $R^4$ are as defined in claim 1, $R^9$ is as defined for $R^6$ in formula I, with the proviso that it may represent, instead of a group of formula IV, a group of formula

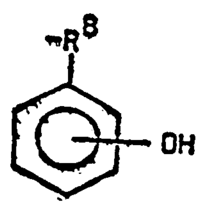

VIII

in which $R^8$ is as defined in claim 2, and Z represents a hydroxyl or alkoxy group or a halogen atom, and x

denotes zero, 1, 2 or 3.

13. A process according to claim 11 or 12, in which the amount of (D) is from 0.04 to 0.75 mole per equivalent of phenolic hydroxyl group in (A), and the amount of (E) is from 0.02 to 0.5 mole per equivalent of phenolic hydroxyl group in (A), and in which the reaction between (E) and (A), or between (E) and the reaction product of (A) and (D), is effected in an inert solvent at a temperature of from 40 to 150°C.

14. A process for the production of an image, which comprises applying by electrodeposition a layer comprising a resin according to any of claims 1 to 10 onto a substrate, exposing the electrodeposited layer to actinic radiation in a predetermined pattern and removing exposed areas by contact with a developer.

## Revendications

1. Résines novolaques phénoliques modifiées, au moins partiellement à l'état de sels, qui sont électrodéposables et photosensibles et qui répondent à la formule générale I :

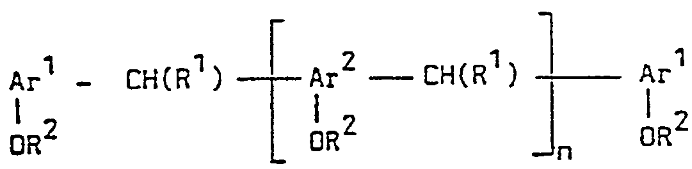

I

dans laquelle $Ar^1$ représente un radical aromatique divalent relié par des atomes de carbone aromatiques aux radicaux $-OR^2$ et $-CH(R^1)-$ représentés, $Ar^2$ représente un radical aromatique trivalent lié par des atomes de carbone aromatiques aux radicaux $-OR^2$ et $-CH(R^1)-$ représentés, $R^1$ représente un atome d'hydrogène ou un radical alkyle, aryle ou carboxy, $R^2$ représente un atome d'hydrogène, un radical alkyle éventuellement porteur d'un hydroxy ou d'un alcoxy, ou un radical de formule $-CO-R^3-COOH$, $-SO_2R^4$, $-COR^5$ ou $-SO_2R^5$, au moins 1% des radicaux $R^2$ désignant un radical $-CO-R^3-COOH$ et au moins 4% des radicaux $R^2$ désignant un radical $-SO_2R^4$, $R^3$ représentant un radical divalent aliphatique, cycloaliphatique, aromatique ou araliphatique, $R^4$ un radical de benzoquinone-1,2 diazide ou naphtoquinone-1,2 diazide de formule :

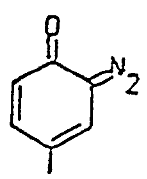

ou

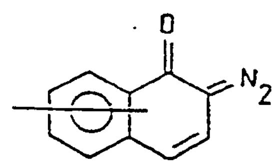

II

III

la liaison de valence libre présente dans la formule III se trouvant à la position 4 ou à la position 5, et $R^5$ un radical univalent aliphatique, cycloaliphatique, aromatique ou araliphatique dépourvu de radical carboxy, et n désigne un nombre entier de 0 à 20.

2. Résines selon la revendication 1 caractérisées en ce que les radicaux $Ar^1$ et $Ar^2$ contiennent de 6 à 25 atomes de carbone et portent éventuellement, sur un atome de carbone aromatique, un substituant $R^6$ qui est un atome d'halogène, un radical de formule $-OR^2$, un radical d'acide carboxylique ou d'acide sulfonique éventuellement estérifié, un radical alkyle, alcényle ou aryle éventuellement porteur d'un hydroxy ou d'un carboxy, ou un radical de formule $-COR^7$ dont le symbole $R^7$ représente un radical alkyle, cycloalkyle ou aryle, ou un radical sur chaque cycle aromatique peut représenter un radical de formule IV :

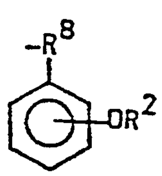

IV

qui est éventuellement relié par des radicaux $-CH(R^1)-$ à des cycles aromatiques voisins, le symbole $R^8$ représentant un atome d'oxygène ou de soufre, un radical carbonyle ou sulfonyle ou un radical alkylène contenant de 1 à 8 atomes de carbone et éventuellement porteur d'un atome d'halogène, d'un hydroxy éventuellement éthérifié, d'un carboxy éventuellement estérifié ou d'un aryle contenant de 6 à 12 atomes de carbone et éventuellement porteur d'un atome d'halogène ou d'un radical hydroxy éventuellement éthérifié ou d'un carboxy éventuellement estérifié, ou, dans le cas où deux substituants $R^6$ se trouvent sur des atomes de carbone voisins, les deux substituants $R^6$ forment ensemble, et avec les atomes de carbone auxquels ils sont liés, un radical benz.

3. Résines selon l'une des revendications 1 et 2, caractérisées en ce qu'elles répondent à la formule générale V:

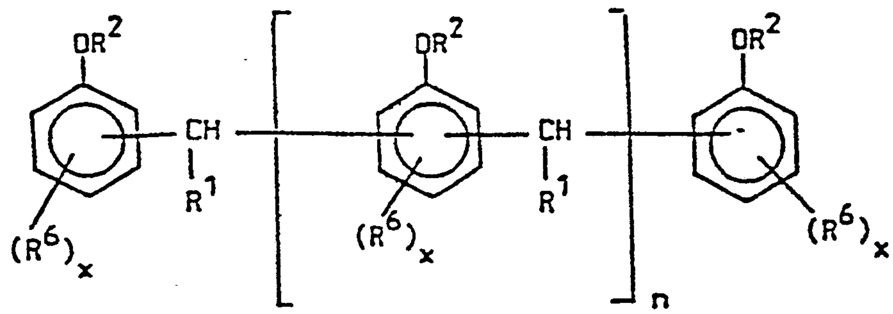

V

dans laquelle $R^1$, $R^2$ et n ont les significations qui leur ont été données à la revendication 1, $R^6$ a les significations indiquées à la revendication 2 et x est égal à 0, à 1, à 2 ou à 3.

4. Résines selon l'une quelconque des revendications 1, 2 et 3, caractérisées en ce que de 8 à 75% des radicaux R2 représentent un radical de formule $-SO_2R^4$, et de 2 à 50% un radical de formule $-CO-R^3-COOH$.

5. Résines selon l'une quelconque des revendications précédentes, caractérisées en ce que des radicaux alkyles, alcoxy et alcényles $R^1$, $R^2$, $R^6$ et $R^7$ peuvent contenir jusqu'à 20 atomes de carbone, des radicaux aryles et aralkyles $R^1$, $R^6$ et $R^7$ jusqu'à 20 atomes de carbone, et des radicaux univalents $R^5$ ainsi que des radicaux divalents $R^3$ jusqu'à 25 atomes de carbone.

6. Résines selon l'une quelconque des revendications précédentes, caractérisées en ce que $R^1$ représente un atome d'hydrogène ou un radical méthyle, éthyle, phényle ou carboxy.

7. Résines selon l'une quelconque des revendications précédentes, caractérisées en ce que $R^3$ représente un radical hydrocarboné divalent qui porte éventuellement un ou plusieurs atomes d'halogènes, un ou plusieurs radicaux alcoxy contenant de 1 à 4 atomes de carbone ou un ou plusieurs radicaux carboxy éventuellement estérifiés.

8. Résines selon la revendication 7 caractérisées en ce que $R^3$ représente le radical que laisse un acide polycarboxylique aliphatique, cycloaliphatique ou aromatique contenant de 4 à 20 atomes de carbone après qu'il a été amputé de deux radicaux carboxy.

9. Résines selon l'une quelconque des revendications 3 à 8, caractérisées en ce que : x est égal à 0, ou x est égal à 1 et les $R^6$ représentent des alkyles identiques ou différents qui contiennent chacun de 1 à 9 atomes de carbone, ou un radical de formule IV dans lequel $R^8$ représente un radical méthylène ou isopropylidène, ou x est égal à 0 pour une partie des cycles aromatiques indiqués et à 1 pour ceux qui restent, les radicaux $R^6$ étant des alkyles, identiques ou différents, qui contiennent de 1 à 9 atomes de carbone, ou x est égal à 1 pour une partie des cycles aromatiques indiqués, les radicaux $R^6$ étant des alkyles, identiques ou différents, contenant de 1 à 9 atomes de carbone, et est égal à 2 pour les cycles restants, les deux radicaux $R^6$ occupant les positions 2 et 3 par rapport aux radicaux $OR^2$ indiqués, et les radicaux $R^6$ formant ensemble, et avec les atomes de carbone auxquels ils sont liés, un radical benzo non substitué.

10. Sels de résines selon l'une quelconque des revendications précédentes, caractérisés en ce qu'ils sont solubles ou dispersables dans un milieu aqueux.

11. Procédé pour préparer des résines novolaques phénoliques modifiées photosensibles, procédé caractérisé en ce qu'on fait réagir une résine novolaque phénolique (A), préparée à partir d'un phénol (B) et d'un aldéhyde (C), avec un acide quinone-diazide-sulfonique (D) ou un dérivé réactif de ce composé, et on continue à faire réagir, pendant 2 à 8 heures, au moins un produit de l'ensemble constitué par (A), (B) et le produit de réaction de (A) et (D), avec un anhydride d'acide polycarboxylique (E) répondant à la formule VI :

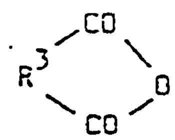

VI

dans laquelle R3 a la signification qui lui a été donnée à la revendication 1, l'acide quinone-diazide-sulfonique ou son dérivé (D) étant mis en jeu en une quantité d'au moins 0,04 mol, et l'anhydride (E) en une quantité d'au moins 0,01 mol, par équivalent de radical hydroxy phénolique dans la novolaque (A) ou dans le phénol (B).

12. Procédé selon la revendication 11 caractérisé en ce que le phénol (B) répond à la formule VII :

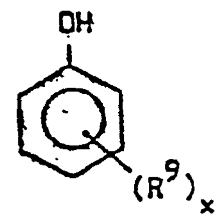

VII,

l'aldéhyde (C) à la formule $R^1CHO$, et le quinone-diazide (D) à la formule $R^4SO_2Z$, $R^1$ et $R^4$ ayant les significations indiquées à la revendication 1, $R^9$ ayant la même signification que $R^6$ dans la formule I avec la condition qu'il puisse représenter, au lieu d'un radical de formule IV, un radical de formule VIII :

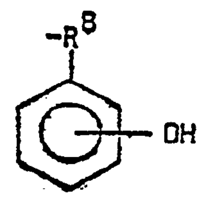

VIII

dans lequel $R^8$ a la signification indiquée à la revendication 2, Z représentant un radical hydroxy ou alcoxy ou un atome d'halogène,et x étant égal à 0, à 1, à 2 ou à 3.

13. Procédé selon l'une des revendications 11 et 12, caractérisé en ce que la quantité de (D) est comprise entre 0,04 et 0,75 mol par équivalent de radical hydroxy phénolique dans (A), et la quantité de (E) est comprise entre 0,02 et 0,5 mol par équivalent de radical hydroxy phénolique dans (A), et en ce que la réaction entre (E) et (A), ou entre (E) et le produit de réaction de (A) et (D), est effectuée dans un solvant inerte, à une température de 40 à 150°C.

14. Procédé pour créer une image, caractérisé en ce qu'on applique sur un substrat, par électrodéposition, une couche contenant une résine selon l'une quelconque des revendications 1 à 10, on expose la couche ainsi appliquée à un rayonnement actinique conformément à un modèle donné et on élimine, par mise en contact avec un développateur, les endroits touchés par le rayonnement.